# EUROPEAN PATENT SPECIFICATION

(11) **EP 3 316 338 B1**
(45) Date of publication and mention of the grant of the patent: **24.10.2018**
(21) Application number: 16195706.3
(22) Date of filing: 26.10.2016
(51) Int. Cl.: H01M 2/04, H01M 2/34, H01M 10/48, H01M 10/42, B60L 11/18, H05K 1/18

(54) **BATTERY MODULE WITH A FIXING FOR A TEMPERATURE SENSITIVE ELEMENT**
BATTERIEMODUL MIT EINEM ANSATZ FÜR EIN TEMPERATUREMPFINDLICHES ELEMENT
MODULE DE BATTERIE DOTÉ D'UNE FIXATION POUR UN ÉLÉMENT SENSIBLE À LA TEMPÉRATURE

(43) Date of publication of application: 02.05.2018
(73) Proprietor: Samsung SDI Co., Ltd., Giheung-gu Yongin-si, Gyeonggi-do 17084 (KR)
(72) Inventor: Hammerschmied, Helmut, 8020 Graz (AT); Hofer, Maximilian, 8230 Hartberg (AT); Cotic, Urban, 2344 Lovrenc na Pohorju (SI)
(74) Representative: Gulde & Partner

(56) References cited:
- US-A1- 2013 209 846
- US-A1- 2015 072 193
- US-A1- 2015 214 583

## Description

### Field of the Invention

The present invention relates to a battery module comprising a specific arrangement of a fixing between a protective circuit module and a temperature sensitive element suitable for measurement of a battery cell temperature.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs each battery is coupled to a common current collector structure and a common battery management system and the unit thereof is housed. In modular designs, pluralities of battery cells are connected to form submodules and several submodules are connected to form the module. The battery management functions can then be at least partially realized on either module or submodule level and thus interchangeability might be improved. One or more battery modules are mechanically and electrically integrated, equipped with a thermal management system and set up for communication with one or more electrical consumers in order to form a battery system. The thermal management system includes usually a protective circuit module which is arranged next to the battery cells.

For meeting the dynamic power demands of various electrical consumers connected to the battery system a static control of battery power output and charging is not sufficient. Thus, steady exchange of information between the battery system and the controllers of the electrical consumers is required. These information includes the battery systems actual state of charge (SoC), potential electrical performance, charging ability and internal resistance as well as actual or predicted power demands or surpluses of the consumers. One parameter controlling the state of each battery cell is the battery cell temperature. Therefore, temperature sensitive elements are provided within the battery module. Meanwhile, some solutions have been provided as how to keep the temperature sensitive element at the surface of the battery cell, since especially in automotive applications there may be strong external impacts. Each of these attempts includes mechanical complex arrangements of fixings with several parts thereby increasing significantly the costs of the battery module due to high manufacturing and material costs.

For example, US 2015/0214583 A1 discloses a battery module comprising a plurality of battery cells aligned in one direction and a temperature sensor having a first surface contacting at least one battery cell of the plurality of battery cells to measure a temperature of the at least one battery cell. The battery module further includes a case configured to press against a second surface of the temperature sensor opposite to the first surface. The case comprises a leaf spring pressing the temperature sensor in the direction of the battery cell.

Another example for ensuring close contact between the temperature sensor and the battery cell is disclosed in JP 5703458 B2.

It is an object of the present invention to overcome or reduce at least some of the drawbacks of the prior art and to provide a battery system that may be established by a simple manufacturing process using non-expensive elements.

### Summary of Invention

One or more of the drawbacks of the prior art could be avoided or at least reduced by means of the present invention. In particular, a battery module is provided comprising:
- at least one battery cell;
- a protective circuit module electrically coupled to the battery cell and including a rigid printed circuit board;
- at least one temperature sensitive element provided at a surface of the battery cell;
- a flexible printed circuit board including a first end portion, a second end portion and an inner portion connecting the first end portion and the second end portion, the flexible printed circuit board being fixed with the first end portion and the second end portion to a surface of the rigid printed circuit board facing the battery cell such that the inner portion forms a loop, wherein the flexible printed circuit board is electrically connecting the protective circuit module and the temperature sensitive element and wherein the temperature sensitive element is centrally positioned on the inner portion of the flexible printed circuit board; and
- a spring element being arranged within the loop of the flexible printed circuit board such that the temperature sensitive element is pushed towards the battery cell.

Thus, one aspect of the present invention is to provide a battery module, wherein a position and functionality of the temperature sensitive element at the surface of the battery cell is even ensured when a relative movement of the battery cell and the protective circuit module occurs due to external impact. Furthermore, the manufacturing process should be still simply to keep the manufacturing costs low. This is achieved by arranging the temperature sensitive element on a loop of a flexible printed circuit board, which also establishes a sensing contact between the temperature sensitive element and the protective circuit module. The area bearing the temperature sensitive element is in close contact with the surface of the battery cell by spring force. Therefore, a spring element is positioned within the loop and pushes the temperature sensitive element against the battery cell.

A flexible circuit in its purest form is a vast array of conductors bonded to a thin dielectric film. Flex circuits require less manual labor during assembly and reduce production errors. Flex circuits have an intrinsic ability to integrate form, fit and function. Flex circuits eliminate the high cost of routing, wrapping and soldering wires. As a result, wiring errors are eliminated and hence manufacturing costs are reduced. However, rigid flex circuits provide higher component density and thus the protective circuit module cannot be established as a flexible printed circuit board itself. Hence, the battery module of the present invention combines the benefits of rigid and flexible circuits.

According to one embodiment, the spring element includes a rounded portion to lie against the inner portion of the flexible printed circuit board bearing the temperature sensitive element. In other words, the spring element has a curved portion supporting the section of the flexible printed circuit board, where the temperature sensitive element is placed to be bent outwards. Thus, the temperature sensitive elements come into closed contact with the battery cell when the protective circuit module is mounted onto the battery cells. Due to the spring force, the closed contact is ensured even in case of external impact and small relative movement of battery cell and protective circuit module. Furthermore, the manufacturing process is simplified. There is no need to separately mount or fix the position of the temperature sensitive element(s). A contact between a wiring pattern of the rigid printed circuit board and the flexible printed circuit board may thus be easily established before both compounds are assembled with the battery cells and other parts of the battery module.

According to another embodiment, a lower part of the spring element is fixed by a bracket. Preferably, the bracket includes a first bolt provided at a first side surface of the bracket and a second bolt provided at a second side surface of the bracket. The flexible printed circuit board is tightly fixed at the first and second bolts on the bracket. Thus, the bracket is a rigid member positioned closed to the rigid printed circuit board. The bracket deals to accommodate and support a lower part of the spring element. Consequently, the upper part of the spring element cannot slip out of the loop of the flexible printed circuit board. Furthermore, the optional bolts on side surfaces of the bracket help to keep the loop in position such that the loop substantially extends perpendicular from the rigid printed circuit board of the protective circuit module. In addition, the manufacturing process is simplified since the flexible printed circuit board may be pre-mounted on the composite of spring element and bracket. Thus, solely electrical contact between the free end portions of the flexible printed circuit board and the rigid printed circuit board must be established, for example by a common soldering process.

The bracket is preferably fixed on the rigid printed circuit board. The bracket and the rigid printed circuit board may be connected by at least one form-locked connecting element. The form-locked connecting element may be a bolt provided at or being a part of the bracket and the rigid printed circuit board includes a corresponding hole for accommodation of the bolt.

Thus, the bracket includes connecting means to ensure the exact position of the temperature sensitive element on the protective circuit board. Using a form-locked connecting element simplifies the manufacturing process.

The bracket may be made of plastics, in particular a dielectric polymer. Thus, the fixing of the temperature sensitive element could be achieved by cost-effective compounds, namely a common flexible printed circuit board, a simple spring element and a bracket made of a cheap material and having an unpretentious mechanical constitution.

According to another aspect of the present invention, a vehicle including a battery module as defined above is provided. The vehicle may be an automobile.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a perspective view of a battery module.
- Fig. 2: is a partially cut-away cross-sectional view of a part of a battery module including a fixing for a temperature sensitive element according to an embodiment of the present invention.
- Fig. 3: is an enlarged perspective view on a fixing for a temperature sensitive element according to another embodiment of the invention.
- Fig. 4-6: are different enlarged perspective views on the fixing of Figure 3.
- Fig. 7: separately illustrates the unmounted fixing of Figure 3.
- Fig. 8: illustrates a spring element useful for the fixing according to the embodiment of Figure 3.
- Fig. 9: illustrates a plan view on a flexible printed circuit board useful for the fixing according to the embodiment of Figure 3.
- Fig. 10: illustrates a partially cross-sectional view on the flexible printed circuit board of Figure 9.

### Detailed Description of the Invention

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

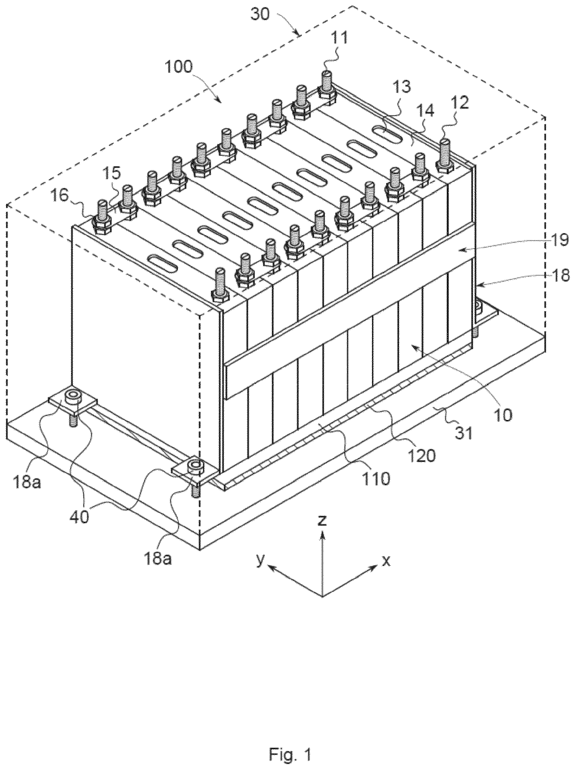

Referring to FIG. 1, an exemplary embodiment of a conventional battery module 100 includes a plurality of battery cells 10 aligned in one direction and a heat exchange member 110 provided adjacent to a bottom surface of the plurality of battery cells 10. A pair of end plates 18 are provided to face wide surfaces of the battery cells 10 at the outside of the battery cells 10, and a connection plate 19 is configured to connect the pair of end plates 18 to each other thereby fixing the plurality of battery cells 10 together. Fastening portions 18a on both sides of the battery module 100 are fastened to a support plate 31 by bolts 40. The support plate 31 is part of a housing 30. In addition, an elastic member 120 made of rubber or other elastic materials may be interposed between the support plate 31 and the heat exchange member 110.

Here, each battery cell 10 is a prismatic (or rectangular) cell, the wide flat surfaces of the cells being stacked together to form the battery module. Further, each battery cell 10 includes a battery case configured for accommodation of an electrode assembly and an electrolyte. The battery case is hermetically sealed by a cap assembly 14. The cap assembly 14 is provided with positive and negative electrode terminals 11 and 12 having different polarities, and a vent 13. The vent 13 is a safety means of the battery cell 10, which acts as a passage through which gas generated in the battery cell 10 is exhausted to the outside of the battery cell 10. The positive and negative electrode terminals 11 and 12 of neighboring battery cells 10 are electrically connected through a bus bar 15, and the bus bar 15 may be fixed by a nut 16 or the like. Hence, the battery module 100 may be used as power source unit by electrically connecting the plurality of battery cells 10 as one bundle. Rechargeable secondary batteries may be used as the battery cells 10, especially lithium secondary batteries. The battery module 100 may be a 48V battery for automotive application.

Generally, the battery cells 10 generate a large amount of heat while being charged/discharged. The generated heat is accumulated in the battery cells 10, thereby accelerating the deterioration of the battery cells 10. Therefore, the battery module 100 further includes a heat exchange member 110, which is provided adjacent to the bottom surface of the battery cells 10 so as to cool down the battery cells 10. Furthermore, the battery module 100 includes means for detecting the temperature of the battery cells 10 in order to safely operate the battery module 100. These means include a protective circuit module and temperature sensors (not shown in Fig. 1).

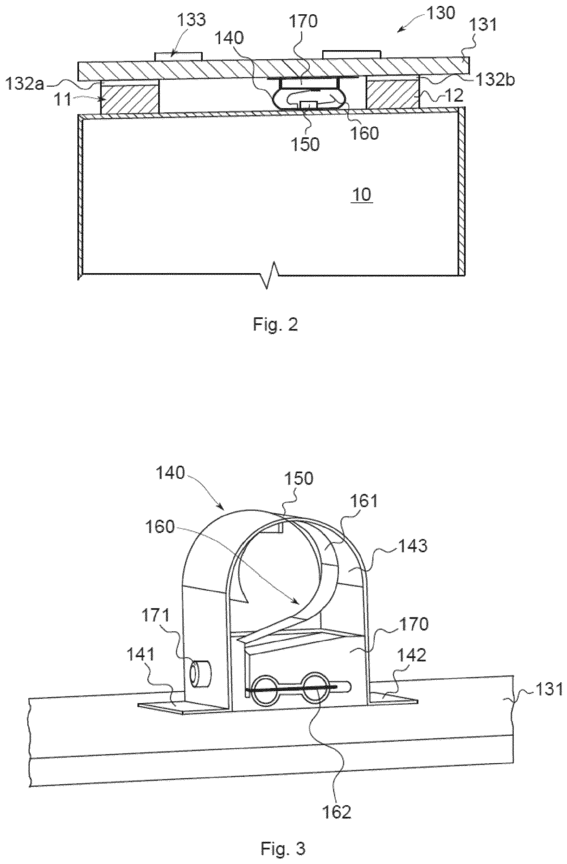

FIG. 2 is a partially cut-away cross-sectional view of one of the battery cells 10 of the battery module 100 of Fig. 1. Referring to Fig. 2 the battery module 100 includes a protective circuit module 130 electrically connected to the battery cell 10. Furthermore, the protective circuit module 130 is electrically connected to a temperature sensitive element 150 via a flexible printed circuit board 140.

In general, each battery cell 10 of the battery module 100 is electrically connected to a protective circuit module 130. According to the present embodiment, there is only one protective circuit module 130, which is connected to all of the battery cells 10 of the battery module 100. However, there may be also two or more separate protective circuit modules being connected to a group of battery cells or single battery cells.

The protective circuit module 130 is made to lie down at sides of the battery cells 10 such that there is a gap between the battery cell surface and the side of the protective circuit module 130 facing the battery cell 10. Here, the protective circuit module 130 is being arranged at the upper surface of the battery cells 10 bearing the electrode terminals 11 and 12. In particular, the protective circuit module 130 is electrically connected to the battery cells 10 to control charging and discharging and preventing the battery cells 110 from being over-charged or over-discharged.

The protective circuit module 130 includes a rigid printed circuit board (PCB) 131 with connection terminals 132a, 132b for the terminals 11, 12 of the battery cell 10 and at least one semiconductor device 133 is formed on an upper surface of the circuit board 131. The semiconductor device 133 may comprise an integrated circuit that is adapted to compare the measured temperature of the battery cell 10 with a limit value for allowable battery cell temperatures. The circuit board 131 includes a wiring pattern (not shown) formed on a surface of the circuit board 131. A main body of the circuit board 131 may be formed of a rigid electrically insulating material like polyimide (PI) or polyethylene (PET). The wiring pattern may be made of an electrically conductive material, such as copper (Cu), titanium (Ti), nickel (Ni), or palladium (Pd).

The connection terminals 132a and 132b may be formed by exposing a portion of the wiring pattern or - as implemented in the present embodiment - by further providing a conductive material, such as gold (Au), on the exposed portion of the wiring pattern.

The semiconductor device 133 applies signals for controlling operations of the battery cells 10. In particular, the semiconductor device 133 controls charging or discharging extents through high current lines of the battery cells 10. In addition, the semiconductor device 133 applies signals indicating voltages, current and temperatures of the battery cells 10 to prevent for example over-charge or over-discharge.

To this end, the semiconductor device 133 applies information about the temperatures of the battery cells 10 via the flexible printed circuit board 140 from the temperature sensitive element 150 and controls the operations of the battery cells 10. Here, the information about the voltages, currents and temperatures may be transferred to the semiconductor device 133 through the wiring pattern of the circuit board 131.

The flexible printed circuit board 140 connects the protective circuit module 130 and the temperature sensitive element 150 provided at a surface of the battery cell 10. According to one embodiment, each battery cell 10 of the battery module 100 includes at least one temperature sensitive element 150 in order to measure the temperature of each battery cell 10 separately. However, in several applications it is sufficient to arrange a minimum of two temperature sensitive elements 150 in the battery module 100.

The flexible printed circuit board 140 includes sensing lines (not shown) for transmitting signals from the connected temperature sensitive element 150 to the protective circuit module 130, thereby allowing the protective circuit module 130 to identify temperature values of the corresponding battery cell 10. The flexible printed circuit board 140 extends between the protective circuit module 130 and the temperature sensitive element 150. Since the flexible printed circuit board 140 can be easily bent, a stable connection is maintained between the both components even if the battery cells 10 or the protective circuit module 130 moves within the housing 30.

Further details of the fixing for the temperature sensitive element 150 will now be described with respect to the embodiment illustrated in FIG. 3.

The flexible printed circuit board 140 includes a first end portion 141, a second end portion 142 and an inner portion 143 connecting the first end portion 141 and the second end portion 142. The flexible printed circuit board 140 is fixed with the first end portion 141 and the second end portion 142 to a surface of the rigid printed circuit board 131 facing the battery cell 10 such that the inner portion 143 forms a loop. The flexible printed circuit board 140 is electrically connecting the protective circuit module 130 and the temperature sensitive element 150. Thus, there may be connectors (not shown) at the rigid printed circuit board 131 where the end portions 141 and 142 may be coupled to a wiring pattern for example by a common soldering process. The temperature sensitive element 150 is centrally positioned on the inner portion 143 of the flexible printed circuit board 140. Here, the temperature sensitive element 150 is provided at an inner surface of the flexible printed circuit board 140. However, the temperature sensitive element 150 may also be provided at the outer surface or integrated into the flexible printed circuit board 140. The fixing further includes a spring element 160 being arranged within the loop of the flexible printed circuit board 140 such that the temperature sensitive element 150 is pushed towards the battery cell 10.

The temperature sensitive element 150 may be a temperature sensor, for instance a negative temperature coefficient (NTC) thermistor, the electrical resistance value of which decreases due to a negative temperature coefficient as the temperature of the battery cells 10 increases, or a positive temperature coefficient (PTC) thermistor, the electrical resistance value of which increases as the temperature of the battery cells 10 increases. Since the temperature sensitive element 150 sensitively reacts to temperature and alters resistance values with temperature, the protective circuit module 130 may control charging and discharging of the battery cells 10.

Specifically, the temperature sensitive element 150 is provided as a chip thermistor. Since the chip thermistor is simply connected to the circuit board 131 of the protective circuit module 130 via the flexible printed circuit board 140 by for example a solder mounting process, the number of overall process steps can be reduced. In addition, such solder mounting can be automated.

In order to hold the temperature sensitive element 150 at the upper surface of the battery cell 10, the spring element 160 is provided within the loop of the flexible printed circuit board 140. Thus, the temperature sensitive element 150 is pressed on the top side of the battery cell 10 with the spring body. In particular, the spring element 160 includes a rounded portion 161 to lie against the inner portion 143 of the flexible printed circuit board 140 bearing the temperature sensitive element 150. Here, the spring element 160 is a leaf spring, but not limited thereto.

Furthermore, the fixing of the embodiment as illustrated in FIG. 3 includes a bracket 170. A lower part 162 of the spring element 160 is fixed by the bracket 170. Thus, the bracket 170 forms a rigid holding for the spring element 160. The bracket 170 may be formed of plastics, especially a dielectric polymer. During the manufacturing process, the spring element 160 is placed into the plastic bracket 170 and fixed by for example hot stamping.

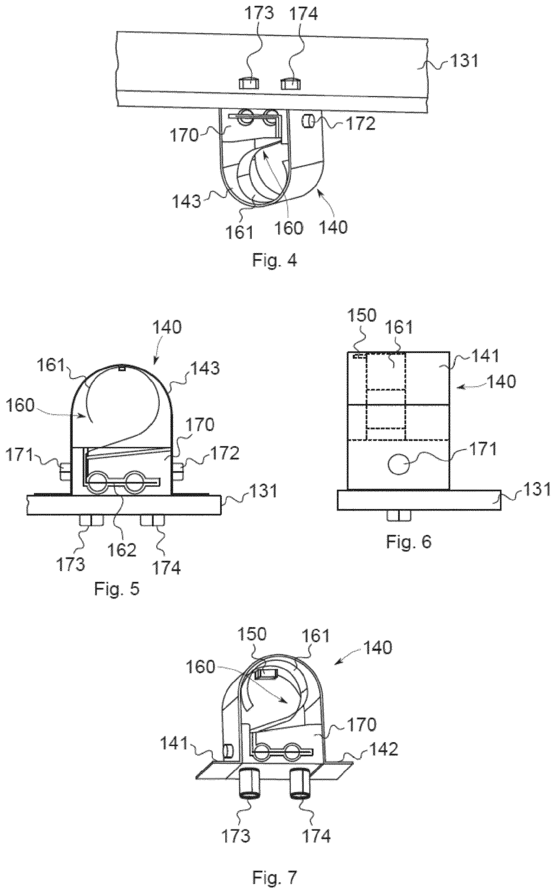

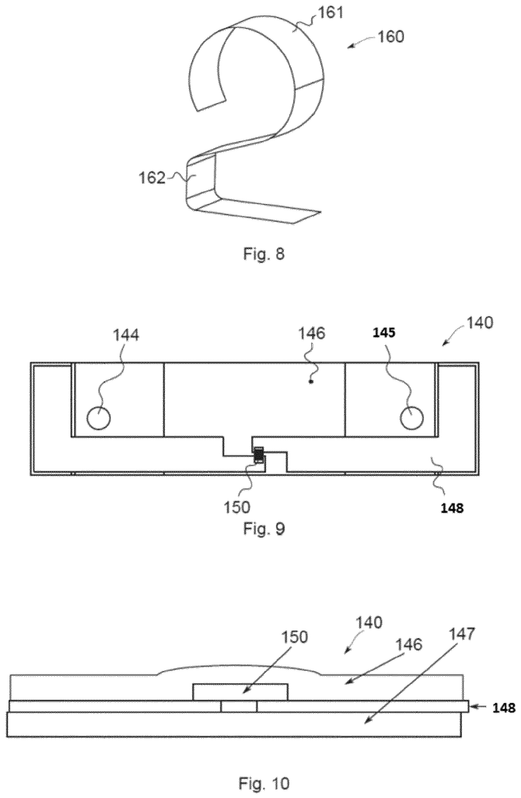

FIGs 4 through 6 illustrate the fixing embodiment of FIG. 3 from different perspectives and FIG. 7 shows the fixing embodiment without the rigid printed circuit board 130. The bracket 170 further includes a first bolt 171 provided at a first side surface of the bracket 170 and a second bolt 172 provided at a second side surface of the bracket 170 opposite to the first side surface. The flexible printed circuit board 140 is tightly fixed at the first and second bolts 171, 172 on the bracket 170. Hence, the flexible printed circuit board 140 includes corresponding holes 144, 145 which are illustrated in FIG. 9 in more detail. During the manufacturing process, the flexible printed circuit module 140 is placed on the spring element 160 such that the bolts 171, 172 reach through the holes 144, 145 and the flexible printed circuit module 140 is tightened. The bolts 171, 172 may be hot stamped to permanently maintain their position.

The bracket 170 is fixed on the rigid printed circuit board 131. Here, both compounds are connected by two form-locked connecting elements. More precisely, the form-locked connecting elements are two bolts 173 and 174 provided at a lower surface of the bracket 170 and being a one-piece part of the same. The rigid printed circuit board 131 includes corresponding holes for accommodation of the bolts 173 and 174. Also the bolts 173, 174 may be hot stamped to permanently maintain their position.

FIG. 8 is a perspective view of the spring element 160 useful for the fixing illustrated in the embodiment of FIG. 3. The upper part 162 shows a rounded contour and the lower part 162 will be placed in the bracket 170. The spring element 160 may be formed of a band of stainless steel. The spring element 160 may have a width of for example 6 mm and a high of for example 10 mm.

Here, a width of the band of the spring element 160 is less than a width of the flexible printed circuit board 140. Thus, the flexible printed circuit board 140 may be placed such that the spring element 160 does not touch the temperature sensitive element 150 in order to avoid any damage thereof. The temperature sensitive element 150 may be preferably provided at an edge of the flexible printed circuit board 140 as illustrated in FIG. 9.

FIG. 9 is a schematically and partially cut-away plan view on the flexible printed circuit board 140 and FIG. 10 a partially cross-sectional view thereof. The flexible printed circuit board 140 includes an electrically conducting layer 148 for example made of copper, which is embedded in between two dielectric layers 146 and 147. The temperature sensitive element 150 bypasses two electrically separated parts of the conducting layer 148. Thus, the temperature sensitive element 150 may be for example an NTC thermistor.

## Claims

1. A battery module (100), comprising:
- at least one battery cell (10);
- a protective circuit module (130) electrically coupled to the battery cell (10) and including a rigid printed circuit board (131);
- at least one temperature sensitive element (150) provided at a surface of the battery cell (10);
- a flexible printed circuit board (140) including a first end portion (141), a second end portion (142) and an inner portion (143) connecting the first end portion (141) and the second end portion (142), the flexible printed circuit board (140) being fixed with the first end portion (141) and the second end portion (142) to a surface of the rigid printed circuit board (131) facing the battery cell (10) such that the inner portion (143) forms a loop, wherein the flexible printed circuit board (140) is electrically connecting the protective circuit module (130) and the temperature sensitive element (150) and wherein the temperature sensitive element (150) is centrally positioned on the inner portion (143) of the flexible printed circuit board (140); and
- a spring element (160) being arranged within the loop of the flexible printed circuit board (140) such that the temperature sensitive element (150) is pushed towards the battery cell (10).

2. The battery module of claim 1, wherein the spring element (160) includes a rounded portion (161) to lie against the inner portion (143) of the flexible printed circuit board (140) bearing the temperature sensitive element (150).

3. The battery module of one of the preceding claims, wherein a lower part (162) of the spring element (160) is fixed by a bracket (170).

4. The battery module of claim 3, wherein the bracket (170) includes a first bolt (171) provided at a first side surface of the bracket (170) and a second bolt (172) provided at a second side surface of the bracket (170) and
wherein the flexible printed circuit board (140) is tightly fixed at the first and second bolts (171, 172) on the bracket (170).

5. The battery module of claim 4, the flexible printed circuit board (140) includes two holes (144, 145) corresponding to the first and second bolts (171, 172), respectively.

6. The battery module of claim 3, wherein the bracket (170) is fixed on the rigid printed circuit board (131).

7. The battery module of claim 6, wherein the bracket (170) and the rigid printed circuit board (131) are connected by at least one form-locked connecting element.

8. The battery module of claim 7, wherein the form-locked connecting element is a bolt (173, 174) provided at or being a part of the bracket (170) and the rigid printed circuit board (131) includes a corresponding hole for accommodation of the bolt (173, 174).

9. The battery module of one of claims 3 through 8, wherein the bracket (170) is made of plastics.

10. A vehicle including a battery module (100) according to one of the preceding claims.

## Patentansprüche

1. Batteriemodul (100), das Folgendes umfasst:
- mindestens eine Batteriezelle (10);
- ein Schutzschaltungsmodul (130), das mit der Batteriezelle (10) elektrisch gekoppelt ist und eine starre gedruckte Leiterplatte (131) beinhaltet;
- mindestens ein temperaturempfindliches Element (150), das an einer Oberfläche der Batteriezelle (10) vorgesehen ist;
- eine flexible gedruckte Leiterplatte (140), die einen ersten Endabschnitt (141), einen zweiten Endabschnitt (142) und einen inneren Abschnitt (143), der den ersten Endabschnitt (141) und den zweiten Endabschnitt (142) verbindet, beinhaltet, wobei die flexible gedruckte Leiterplatte (140) mit dem ersten Endabschnitt (141) und dem zweiten Endabschnitt (142) an einer Oberfläche der starren gedruckten Leiterplatte (131), die der Batteriezelle (10) zugewandt ist, befestigt ist, sodass der innere Abschnitt (143) eine Schleife bildet, wobei die flexible gedruckte Leiterplatte (140) das Schutzschaltungsmodul (130) und das temperaturempfindliche Element (150) elektrisch verbindet und wobei das temperaturempfindliche Element (150) auf dem inneren Abschnitt (143) der flexiblen gedruckten Leiterplatte (140) mittig positioniert ist; und
- ein Federelement (160), das in der Schleife der flexiblen gedruckten Leiterplatte (140) so angeordnet ist, dass das temperaturempfindliche Element (150) gegen die Batteriezelle (10) gedrückt wird.

2. Batteriemodul nach Anspruch 1, wobei das Federelement (160) einen abgerundeten Abschnitt (161) beinhaltet, der an dem inneren Abschnitt (143) der flexiblen gedruckten Leiterplatte (140) anliegt, der das temperaturempfindliche Element (150) trägt.

3. Batteriemodul nach einem der vorangehenden Ansprüche, wobei ein unterer Abschnitt (162) des Federelements (160) durch einen Halter (170) befestigt ist.

4. Batteriemodul nach Anspruch 3, wobei der Halter (170) einen ersten Bolzen (171), der an einer ersten seitlichen Oberfläche des Halters (170) vorgesehen ist, und einen zweiten Bolzen (172), der an einer zweiten seitlichen Oberfläche des Halters (170) vorgesehen ist, beinhaltet und
wobei die flexible gedruckte Leiterplatte (140) fest an dem ersten und zweiten Bolzen (171, 172) an dem Halter (170) befestigt ist.

5. Batteriemodul nach Anspruch 4, wobei die flexible gedruckte Leiterplatte (140) zwei Löcher (144, 145) beinhaltet, die dem ersten bzw. zweiten Bolzen (171, 172) entsprechen.

6. Batteriemodul nach Anspruch 3, wobei der Halter (170) auf der starren gedruckten Leiterplatte (131) befestigt ist.

7. Batteriemodul nach Anspruch 6, wobei der Halter (170) und die starre gedruckte Leiterplatte (131) durch mindestens ein formschlüssiges Verbindungselement verbunden sind.

8. Batteriemodul nach Anspruch 7, wobei das formschlüssige Verbindungselement ein Bolzen (173, 174) ist, der an dem Halter (170) vorgesehen oder ein Teil davon ist, und die starre gedruckte Leiterplatte (131) ein entsprechendes Loch zur Aufnahme des Bolzens (173, 174) beinhaltet.

9. Batteriemodul nach einem der Ansprüche 3 bis 8, wobei der Halter (170) aus Kunststoff hergestellt ist.

10. Fahrzeug, das ein Batteriemodul (100) nach einem der vorangehenden Ansprüche beinhaltet.

## Revendications

1. Module de batterie (100) comprenant :
- au moins un élément de batterie (10) ;
- un module de circuit de protection (130) couplé électriquement à l'élément de batterie (10) et comportant une carte de circuit imprimé rigide (131) ;
- au moins un élément sensible à la température (150) prévu au niveau d'une surface de l'élément de batterie (10) ;
- une carte de circuit imprimé souple (140) comportant une première partie d'extrémité (141), une deuxième partie d'extrémité (142) et une partie interne (143) reliant la première partie d'extrémité (141) et la deuxième partie d'extrémité (142), la carte de circuit imprimé souple (140) étant fixée avec la première partie d'extrémité (141) et la deuxième partie d'extrémité (142) à une surface de la carte de circuit imprimé rigide (131) faisant face à l'élément de batterie (10) de sorte que la partie interne (143) forme une boucle, où la carte de circuit imprimé souple (140) relie électriquement le module de circuit de protection (130) et l'élément sensible à la température (150) et où l'élément sensible à la température (150) est positionné au centre sur la partie interne (143) de la carte de circuit imprimé souple (140) ; et
- un élément élastique (160) étant agencé à l'intérieur de la boucle de la carte de circuit imprimé souple (140) de sorte que l'élément sensible à la température (150) soit poussé vers l'élément de batterie (10).

2. Module de batterie de la revendication 1, dans lequel l'élément élastique (160) comporte une partie arrondie (161) pour s'appuyer contre la partie interne (143) de la carte de circuit imprimé souple (140) portant l'élément sensible à la température (150).

3. Module de batterie de l'une des revendications précédentes, dans lequel une partie inférieure (162) de l'élément élastique (160) est fixée par un support (170).

4. Module de batterie de la revendication 3, dans lequel le support (170) comporte un premier boulon (171) prévu au niveau d'une première surface latérale du support (170) et un deuxième boulon (172) prévu au niveau d'une deuxième surface latérale du support (170) et
où la carte de circuit imprimé souple (140) est fixée fermement au niveau des premier et deuxième boulons (171, 172) sur le support (170).

5. Module de batterie de la revendication 4, la carte de circuit imprimé souple (140) comporte deux trous (144, 145) correspondant aux premier et deuxième boulons (171, 172), respectivement.

6. Module de batterie de la revendication 3, dans lequel le support (170) est fixé sur la carte de circuit imprimé rigide (131).

7. Module de batterie de la revendication 6, dans lequel le support (170) et la carte de circuit imprimé rigide (131) sont reliés par au moins un élément de liaison par complémentarité de forme.

8. Module de batterie de la revendication 7, dans lequel l'élément de liaison par complémentarité de forme est un boulon (173, 174) prévu au niveau de ou faisant partie du support (170) et la carte de circuit imprimé rigide (131) comporte un trou correspondant pour la réception du boulon (173, 174).

9. Module de batterie de l'une des revendications 3 à 8, dans lequel le support (170) est réalisé en plastique.

10. Véhicule comportant un module de batterie (100) selon l'une des revendications précédentes.
